# EUROPÄISCHE PATENTSCHRIFT

(11) **EP 3 817 211 B1**
(45) Veröffentlichungstag und Bekanntmachung des Hinweises auf die Patenterteilung: **20.10.2021**
(21) Anmeldenummer: 19206285.9
(22) Anmeldetag: 30.10.2019
(51) Int. Cl.: H02M 3/337, H02M 1/088, H03K 17/691

(54) **HOCHSPANNUNGSNETZTEIL**
HIGH-VOLTAGE POWER SUPPLY
ALIMENTATION ÉLECTRIQUE HAUTE TENSION

(43) Veröffentlichungstag der Anmeldung: 05.05.2021
(73) Patentinhaber: Lunatone Industrielle Elektronik GmbH, 1210 Wien (AT)
(72) Erfinder: Mair, Alexander, 2285 Breitstetten (AT)
(74) Vertreter: Patentanwaltskanzlei Matschnig & Forsthuber OG

(56) Entgegenhaltungen:
- CN-A- 102 005 928
- DE-A1- 19 817 569
- US-A- 5 930 130
- US-A1- 2014 306 674

## Beschreibung

Die Erfindung betrifft ein Hochspannungsnetzteil zur Wandlung einer Eingangsspannung von über 300 V bis 1000V Gleichspannung hin zu zumindest zwei Ausgangspannungen zwischen 2V und 100V, wobei das Hochspannungsnetzteil zur Wandlung der Spannung
- einen Gegentaktwandler aufweist, der mit
   - einem Spannungseingang zur Aufnahme der Eingangsspannung und
   - zwei Spannungsausgängen zur Ausgabe von zwei zueinander variablen Ausgangsspannungen verbunden ist, wobei der Gegentaktwandler Brückenzweige aufweist und dazu ausgebildet ist, mit einer Schwingungsfrequenz zwischen 100 kHz und 1 MHz zu schwingen, wobei der Gegentaktwandler zur Leistungsübertragung von dem Spannungseingang hin zu den Spannungsausgängen
   - einen Leistungstransformator mit einer mit dem Spannungseingang verbundenen
      ∘ Leistungsprimärspule und
      ∘ einer mit den Spannungsausgängen verbundenen Leistungssekundärspule aufweist, die mit der Leistungsprimärspule magnetisch gekoppelt ist,
   wobei die Spannungsausgänge je nach Schaltphase des Gegentaktwandlers wechselweise über die Leistungssekundärspule bestromt und jeweils zumindest mittels eines Hilfskondensators gestützt werden.

Die Erfindung betrifft weiters ein Beleuchtungssystem, umfassend ein erfindungsgemäßes Hochspannungsnetzteil und eine durch das Hochspannungsnetzteil versorgte Leuchteinheit. Solche Hochspannungsnetzteile wurden bisher in einem frei schwingenden Zustand, beispielsweise als frei schwingender LCC-Konverter betrieben. Die Frequenz des freien Schwingungsvorgang wird dabei in Abhängigkeit von den Eigenschaften des Transformators festgelegt.

Eine Aufgabe der Erfindung besteht daher darin, ein energieeffizienteres Hochspannungsnetzteil zu schaffen das zwei zueinander variable Ausgangsspannungen, für zum Beispiel 2 LED Module mit verschiedenen Farbtemperaturen, bereitstellen kann um gezielt voneinander abweichende Lastströme auszugleichen oder absichtlich zu erzwingen.

Diese Aufgabe wird mit einem Hochspannungsnetzteil der eingangs genannten Art gelöst, bei dem erfindungsgemäß nach Anspruch 1 der Gegentaktwandler weiters
- einen Steuertransformator aufweist, der zumindest einen Teil der Spannung an der Leistungsprimärspule über einen elektrischen Widerstand mittels einer Steuertransformatorprimärspule abgreift, und zumindest drei mit der Steuertransformatorprimärspule magnetisch gekoppelte Steuertransformatorsekundärspulen aufweist, wobei eine erste und eine zweite der zumindest drei Steuertransformatorsekundärspulen dergestalt mit primärseitigen Schaltelementen des Gegentaktwandlers verschaltet sind, dass in Abhängigkeit von dem Erreichen einer Sättigung der Steuertransformatorprimärspule die Schwingfrequenz eines frei selbstschwingenden Grundzustandes des Gegentaktwandlers festgelegt ist, indem jedenfalls ein Sättigen der Steuertransformatorprimärspule durch daraus resultierende Spannungssenkung an der ersten und zweiten Steuertransformatorsekundärspule zu einem Wechsel des Vorzeichens der Bestromung der Leistungstransformatorprimärspule führt,
wobei das Hochspannungsnetzteil weiters
- eine Steuereinheit aufweist, wobei die Steuereinheit mit der Sekundärseite des Gegentaktwandlers zur elektrischen Versorgung der Steuereinheit verbunden ist, wobei die Steuereinheit ferner mit zumindest einer dritten Steuertransformatorsekundärwicklung des Steuerungstransformators zur Manipulation der Spannung an derselben, nämlich zur zeitlich vorgebbaren Senkung der Spannung zumindest der dritten Steuertransformatorsekundärwicklung, insbesondere zum Kurzschließen derselben, verbunden ist,
wobei der Gegentaktwandler dergestalt ausgelegt ist, dass durch diese Manipulation gleichermaßen die Spannung an der ersten und zweiten Steuertransformatorsekundärwicklung aufgrund der magnetischen Kopplung der Steuertransformatorwicklungen reduziert, insbesondere kurzgeschlossen, wird, und damit bereits vor Erreichen einer sich im frei schwingenden Grundzustand einstellenden Sättigung der Steuertransformatorprimärwicklung ein Umschwingvorgang eingeleitet und somit die Arbeitsfrequenz des Gegentaktwandlers über seine Grundschwingungsfrequenz hinaus erhöht wird, wobei die Steuereinheit dazu eingerichtet ist, das Verhältnis der Einschaltzeitdauern der Brückenzweige des Gegentaktwandlers abweichend von 50% vorzugeben und so auch das Verhältnis der Ausgangsspannungen zu verändern, in Abhängigkeit von einer vorgebbaren Gewichtung.

Durch die Verwendung des Steuertransformators in Verbindung mit der Steuereinheit ist es möglich, einen Umschwingvorgang bereits vor Erreichen der Sättigung des Steuertransformators, d.h. vor Erreichen der frei schwingenden Periodenzeitdauer, einzuleiten. Damit kann die Arbeitsfrequenz des Hochspannungstransformators über die Grundfrequenz hinaus erhöht werden. Somit ist es möglich, das Hochspannungsnetzteil ohne Erfordernis einer Sättigung hochfrequent mittels dem Steuertransformator in Verbindung mit der Steuereinheit zu betreiben und die Frequenz zu steuern. Die Steuereinheit wird dabei durch die Sekundärseite des Gegentaktwandlers versorgt. Bei einem Startvorgang des Hochspannungsnetzteils schwingt dieses zuerst in einem symmetrischen Grundschwingungszustand, sodass die sekundärseitigen Kondensatoren geladen werden und die Steuereinheit mit Energie versorgt wird. Im Anschluss kann die Steuereinheit den Betrieb aufnehmen und in Abhängigkeit von einem vorgebbaren Wert die Arbeitsfrequenz des Hochspannungsnetzteils durch Manipulation der Spannung an zumindest der dritten Steuertransformatorsekundärwicklung zu erhöhen. Durch das erfindungsgemäße Hochspannungsnetzteil kann ein robustes Hochspannungsnetzteil für breiten Temperaturbereich und mit hoher Lebensdauer geschaffen werden. Insbesondere kann bei dem Hochspannungsnetzteil nach dem Oberbegriff von Anspruch 1 vorgesehen sein, dass
1) die primärseitigen Schaltelemente sich vorzugshalber jeweils aus einem Hochspannungstransistor und einem Kleinspannungstransistor zusammensetzen.
2) Der Kleinspannungstransistor vorzugshalber ein Logik Mosfet ist und mittels eines Steuertransformators 1V bis 15V Pulse zur Versorgung der Gate Ansteuerung des Hochspannungstransistors als auch zur Steuerung des Logik Mosfet, übertragen werden.
3) durch unterschiedliche Einschaltzeitdauern der Brückenzweige unterschiedliche Ausgangsspannungen erzwungen werden.
4) Die Steuereinheit sekundär angeordnet ist und ein erster Start des Netzteils selbstschwingenden erfolgt und die Steuerspannung und Energie von einer HilfsWicklung vorzugshalber einer Sekundärwicklung des Leistungsübertragers abgeleitet wird.
5) Die im selbstschwingenden Zustand an der Sekundärwicklung oder Hilfswicklung auftretenden und dem Steuertransformator über ein strombegrenzendes Glied zugeführten Spannungspulse von einer Steuereinheit manipuliert werden um dadurch abweichende Betriebszustände einzustellen.
6) Die im selbstschwingenden Zustand an der Sekundärwicklung oder Hilfswicklung auftretenden und dem Steuertransformator über ein strombegrenzendes Glied zugeführten Spannungspulse kurzzuschließen um dadurch die Energiezufuhr einzuschränken bzw. zu unterbrechen.
7)Dass die sekundärseitigen Stützkondensatoren beim Start über Ladewiderstände aufgeladen werden.

Es können sämtliche oder auch beliebige Kombinationen dieser Merkmale vorgesehen sein. Ebenso können diese Merkmale beliebig mit den Merkmalen der abhängigen Ansprüche kombiniert werden.

Insbesondere kann vorgesehen sein, dass das Hochspannungsnetzteil dazu eingerichtet ist, die Arbeitsfrequenz bis zumindest einem Faktor 2, vorzugsweise Faktor 3 über die Grundfrequenz hinaus zu erhöhen. Das bedeutet, dass gleichzeitig die Zeitdauer, für die ein Brückenzweig bis zu dem Umschwingvorgang jeweils in Betrieb ist, um den entsprechenden Faktor verkürzt wird.

Weiters kann vorgesehen sein, dass der Steuertransformator eine vierte Steuertransformatorsekundärspule aufweist, wobei die Steuereinheit sowohl mit der dritten als auch mit der vierten Steuertransformatorsekundärspule verbunden ist, wobei die dritte und die vierte Steuertransformatorsekundärspule für komplementäre Schaltperioden des Gegentaktwandlers vorgesehen sind, und die Steuereinheit dazu eingerichtet ist, die Spannung an beiden Steuertransformatorsekundärspulen im jeweiligen Takt nacheinander und unabhängig voneinander zu manipulieren, insbesondere zu Senken und besonders bevorzugt kurzzuschließen.

Insbesondere kann vorgesehen sein, dass die Steuereinheit dazu eingerichtet ist, das Verhältnis der Einschaltzeitdauern der Brückenzweige des Gegentaktwandlers in Abhängigkeit von einer vorgebbaren Gewichtung der über die Spannungsausgänge ausgebbaren Ausgangsspannungen zu manipulieren. Auf diese Weise lassen sich bei jeweils unterschiedlichen Einschaltzeitdauern unterschiedliche Ausgangsspannungen an den Spannungsausgängen realisieren. Zudem kann vorgesehen sein, dass die Steuereinheit dazu eingerichtet ist, die Spannung an beiden Spannungsausgängen oder die jeweiligen Lastströme zu messen und das Verhältnis der Einschaltzeitdauern der Brückenzweige des Gegentaktwandlers unter Berücksichtigung der vorgegebenen Gewichtung sowie der aktuell gemessenen Werte zu manipulieren und eine etwaige Abweichung von der vorgegebenen Gewichtung zu reduzieren. Solche Abweichungen von der Sollgewichtung könnten z.B. durch unterschiedliche Leistungsaufnahme der den Spannungsausgängen zugeordneten Verbrauchern verursacht sein.

Weiters kann vorgesehen sein, dass der Steuertransformator ein Niederspannungstransformator ist. Insbesondere kann vorgesehen sein, dass die Arbeitsspannung des Niederspannungstransformators zwischen 1 und 15V liegt.

Weiters kann vorgesehen sein, dass der Gegentaktwandler an seiner Primärseite zwei Brückenzweige zur Teilung der Eingangsspannung aufweist, wobei jeder Brückenzweig je zwei in Serie geschaltete Schaltelemente aufweist, nämlich je einen Hochspannungstransistor und einen Niederspannungstransistor, wobei die erste und zweite Steuertransformatorsekundärspulen jeweils dergestalt verschaltet sind, dass ein Lastwechsel zwischen den Brückenzweigen durch ein Abschalten des jeweils in Betrieb befindlichen Niederspannungstransistors eingeleitet wird, wodurch die Spannungsdifferenz am Steuereingang des seriell geschalteten Hochspannungstransistors sinkt und dieser ebenso abschaltet, wobei aufgrund der Induktivität des Leistungstransformators eine Spannungsumkehr an der Steuertransformatorprimärwicklung stattfindet, die auf die Steuertransformatorsekundärwicklungen übertragen wird und ein Durchschalten der vor dem Lastwechsel nicht in Betrieb befindlichen Transistoren bewirkt und damit den Lastwechsel zwischen den Brückenzweigen vollzieht. Auf diese Weise wird eine sehr robuste und praxisgerechte Ausführung eines Hochspannungsnetzteils geschaffen.

Zur Verringerung der Einschaltstromaufnahme kann vorgesehen sein, dass die zwei Spannungsausgänge jeweils durch einen Hilfskondensator und einen Hauptkondensator gestützt sind, der eine größere Kapazität als der jeweilige Hilfskondensator aufweist, wobei jeder Hauptkondensator zur Verminderung des Einschaltstromes des Hochspannungsnetzteils mit einem elektrischen Widerstand in Serie geschaltet ist, der über einen parallel geschalteten Transistor kurzschließbar ist, wobei die Steuereinheit dazu eingerichtet ist, nach Ablauf einer vorgebbaren Einschwingzeitdauer diese seriellen Widerstände mittels den parallel geschalteten Transistoren kurzzuschließen.

Die Erfindung betrifft weiters ein Beleuchtungssystem, umfassend ein erfindungsgemäßes Hochspannungsnetzteil und eine durch das Hochspannungsnetzteil versorgte Leuchteinheit. Weiters kann vorgesehen sein, dass die Leuchteinheit zumindest zwei Lichtquellen aufweist, wobei eine Lichtquelle mit dem ersten Spannungsausgang und eine weitere Lichtquelle mit dem zweiten Spannungsausgang verbunden ist.

Insbesondere kann vorgesehen sein, dass die zumindest zwei Lichtquellen dazu eingerichtet sind, in Abhängigkeit von der die Lichtquellen versorgenden Spannung den abgestrahlten Lichtstrom und/ oder die Lichtfarbe zu variieren.

Die Erfindung ist im Folgenden anhand einer beispielhaften und nicht einschränkenden Ausführungsform näher erläutert, die in den Figuren veranschaulicht ist. Darin zeigt
Figur 1 eine schematische Darstellung eines Ersatzschaltbildes eines erfindungsgemäßen Hochspannungsnetzteils, und
Figur 2 beispielhafte Spannungsverläufe an dem Hochspannungsnetzteil gemäß Fig. 1.
In den folgenden Figuren bezeichnen - sofern nicht anders angegeben - gleiche Bezugszeichen gleiche Merkmale.

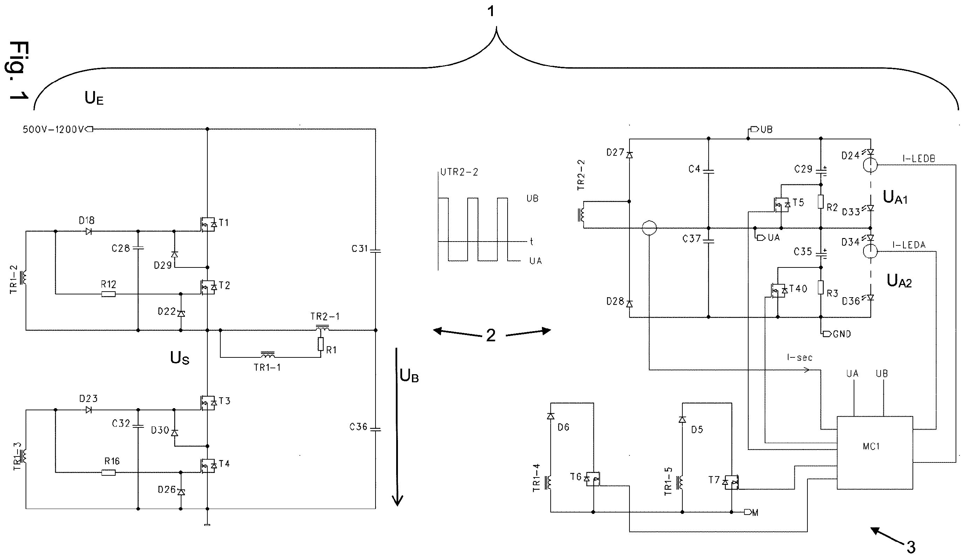

Figur 1 zeigt eine schematische Darstellung eines Ersatzschaltbildes eines erfindungsgemäßen Hochspannungsnetzteils 1.

Das Hochspannungsnetzteil 1 ist zur Wandlung einer Eingangsspannung von über 300 V Gleichspannung hin zu zumindest zwei Ausgangspannungen, im vorliegenden Beispiel hin zu zwei voneinander unterschiedlich einstellbaren Ausgangsspannungen und U_{A2} in Höhe von zwischen 2V und 100V, eingerichtet.

Das Hochspannungsnetzteil 1 weist zur Wandlung der Spannung
- einen Gegentaktwandler 2 auf, der mit
   - einem Spannungseingang U_{E} zur Aufnahme der Eingangsspannung und
   - zwei Spannungsausgängen U_{A1} und U_{A2} zur Ausgabe von zwei Ausgangsspannungen verbunden ist,
      wobei der Gegentaktwandler 2 dazu ausgebildet ist, mit einer Schwingungsfrequenz zwischen 100 kHz und 1 MHz zu schwingen, wobei der Gegentaktwandler 2 zur Leistungsübertragung von dem Spannungseingang U_{E} hin zu den Spannungsausgängen U_{A1} und U_{A2}
   - einen Leistungstransformator mit einer mit dem Spannungseingang U_{E} verbundenen
      ∘ Leistungsprimärspule TR2-1 und
      ∘ einer mit den Spannungsausgängen verbundenen Leistungssekundärspule TR2-2 aufweist, die mit der Leistungsprimärspule TR2-1 magnetisch gekoppelt ist,
      wobei die Spannungsausgänge U_{A1} und U_{A2} je nach Schaltphase des Gegentaktwandlers 2 wechselweise über die Leistungssekundärspule TR2-2 bestromt und jeweils mittels eines Hilfskondensators C4 bzw. C37 gestützt werden.

Der Gegentaktwandler 2 weist weiters
- einen Steuertransformator auf, der zumindest einen Teil der Spannung an der Leistungsprimärspule TR2-1 über einen elektrischen Widerstand R1 mittels einer Steuertransformatorprimärspule TR1-1 abgreift, und zumindest drei, im vorliegenden Beispiel vier mit der Steuertransformatorprimärspule TR1-1 magnetisch gekoppelte Steuertransformatorsekundärspulen TR1-2 bis TR1-5 aufweist, wobei eine erste TR1-2 und eine zweite TR1-2 der zumindest drei Steuertransformatorsekundärspulen dergestalt mit primärseitigen Schaltelementen (vorliegend in Form von Niederspannungstransistoren) T2 und T4 des Gegentaktwandlers 2 verschaltet sind, dass in Abhängigkeit von dem Erreichen einer Sättigung der Steuertransformatorprimärspule TR1-1 die Schwingfrequenz eines frei selbstschwingenden Grundzustandes des Gegentaktwandlers 2 festgelegt ist, indem jedenfalls ein Sättigen der Steuertransformatorprimärspule TR1-1 durch daraus resultierende Spannungssenkung an der ersten und zweiten Steuertransformatorsekundärspule TR1-2 und TR1-3 zu einem Wechsel des Vorzeichens der Bestromung der Leistungstransformatorprimärspule TR2-1 führt.

Das Hochspannungsnetzteil 1 weist weiters
- eine Steuereinheit 3 auf, wobei die Steuereinheit 3 mit der Sekundärseite des Gegentaktwandlers 2 zur elektrischen Versorgung der Steuereinheit 3 verbunden ist, wobei die Steuereinheit 3 ferner mit zumindest einer dritten Steuertransformatorsekundärwicklung TR1-4 des Steuerungstransformators zur Manipulation der Spannung an derselben, nämlich zur zeitlich vorgebbaren Senkung der Spannung zumindest der dritten Steuertransformatorsekundärwicklung TR1-4, insbesondere zum Kurzschließen derselben, verbunden ist. Der Gegentaktwandler 2 ist dergestalt ausgelegt, dass durch diese Manipulation gleichermaßen die Spannung an der ersten und zweiten Steuertransformatorsekundärwicklung TR1-2 und TR1-3 aufgrund der magnetischen Kopplung der Steuertransformatorwicklungen reduziert, insbesondere kurzgeschlossen, wird, und damit bereits vor Erreichen einer sich im frei schwingenden Grundzustand einstellenden Sättigung der Steuertransformatorprimärwicklung TR1-1 ein Umschwingvorgang eingeleitet und somit die Arbeitsfrequenz des Gegentaktwandlers 2 über seine Grundschwingungsfrequenz hinaus erhöht wird.

Der Gegentaktwandler 2 weist primärseitig zwei Brückenzweige auf, über die die am Spannungseingang U_{E} anliegende Eingangsspannung geteilt wird. Über diese Brückenzweige wird die Primärspule TR2-1 des Leistungstransformators wechselweise bestromt. Beispielsweise kann die Bestromung zuerst über einen Zweig erfolgen, der die Transistoren T1 und T2 umfasst, über die Leistungstransformatorprimärspule TR2-1 verläuft und sich über den Kondensator C36 gegen Masse schließt. In einem zweiten Taktabschnitt kann hingegen der Stromfluss durch die Leistungstransformatorprimärspule TR2-1 umgekehrt (und damit die magnetische Ausnutzung optimiert werden), indem der Leistungsfluss nun über den Kondensator C31, die Leistungstransformatorprimärspule TR2-1 und die Transistoren T3 und T4 gegen Masse erfolgt. Anders ausgedrückt, ist die Primärspule entsprechend dem Arbeitstakt über eine Brückenschaltung mittels positiven und negativen Spannungsblöcken über den Spannungseingang versorgbar ist, wobei der Wechsel zwischen den Spannungsblöcken durch Zu- und Wegschaltung von elektrischen Schaltventilen erfolgt, wobei die Ansteuerung der Schaltventile über die Sekundärwicklungen des Steuertransformators erfolgt. Sekundärseitig ist zumindest eine Leistungstransformatorsekundärspule TR2-2 vorgesehen, über die Leistungsübertragung zu den beiden Ausgängen U_{A1} und U_{A2} erfolgt, wobei diese wechselweise entsprechend dem vorliegen eines positiven oder negativen Spannungsblockes versorgt werden.

Der Steuertransformator weist im vorliegenden Ausführungsbeispiel eine vierte Steuertransformatorsekundärspule TR1-5 auf, wobei die Steuereinheit 3 sowohl mit der dritten als auch mit der vierten Steuertransformatorsekundärspule TR1-4, TR1-5 verbunden ist, wobei die dritte und die vierte Steuertransformatorsekundärspule TR1-4, TR1-5 für komplementäre Schaltperioden des Gegentaktwandlers vorgesehen sind, und die Steuereinheit 3 dazu eingerichtet ist, die Spannung an beiden Steuertransformatorsekundärspulen TR1-4, TR1-5 im jeweiligen Takt nacheinander und unabhängig voneinander zu manipulieren, insbesondere zu Senken und besonders bevorzugt kurzzuschließen.

Die Steuereinheit 3 kann dazu eingerichtet sein, das Verhältnis der Einschaltzeitdauern der Brückenzweige des Gegentaktwandlers 2 in Abhängigkeit von einer vorgebbaren Gewichtung der über die Spannungsausgänge U_{A1}, U_{A2} ausgebbaren Ausgangsspannungen zu manipulieren. Durch Vorgabe asymmetrischer Einschaltzeitdauern können z.B. die Ausgangsspannungen voneinander abweichen, was zur gezielten Regelung von mit den Ausgängen verbunden Verbrauchern, insbesondere Lichtquellen, eingesetzt werden kann.

Die Steuereinheit 3 kann dazu eingerichtet sein, die Spannung an beiden Spannungsausgängen U_{A1}, U_{A2} zu messen und das Verhältnis der Einschaltzeitdauern der Brückenzweige des Gegentaktwandlers 2 unter Berücksichtigung der vorgegebenen Gewichtung sowie der aktuell gemessenen Gewichtung zu manipulieren und eine etwaige Abweichung von der vorgegebenen Gewichtung zu reduzieren. Die Arbeitsspannung des Niederspannungstransformators kann vorzugsweise zwischen 1 und 15V liegen.

Vorzugsweise kann vorgesehen sein, dass der Gegentaktwandler 2 an seiner Primärseite zwei Brückenzweige zur Teilung der Eingangsspannung aufweist, wobei jeder Brückenzweig je zwei in Serie geschaltete Schaltelemente T1, T2, T3, T4 aufweist, nämlich je einen Hochspannungstransistor T1, T3 und einen Niederspannungstransistor T2, T4, wobei die erste und zweite Steuertransformatorsekundärspulen TR1-2, TR1-3 jeweils dergestalt verschaltet sind, dass ein Lastwechsel zwischen den Brückenzweigen durch ein Abschalten des jeweils in Betrieb befindlichen Niederspannungstransistors T2, T4 eingeleitet wird, wodurch die Spannungsdifferenz am Steuereingang des seriell geschalteten Hochspannungstransistor T1, T3 sinkt und dieser ebenso abschaltet, wobei aufgrund der Induktivität des Leistungstransfomators eine Spannungsumkehr an der Steuertransformatorprimärwicklung TR1-1 stattfindet, die auf die Steuertransformatorsekundärwicklungen TR1-2, TR1-3 übertragen wird und ein Durchschalten der vor dem Lastwechsel nicht in Betrieb befindlichen Transistoren T3 und T4 oder T1 und T2 bewirkt und damit den Lastwechsel zwischen den Brückenzweigen vollzieht.

Im vorliegenden Ausführungsbeispiel ist beispielsweise vorgesehen, dass die zwei Spannungsausgänge U_{A1}, U_{A2} jeweils durch einen Hauptkondensator C29, C35 gestützt sind, der eine größere Kapazität als der jeweilige Hilfskondensator C29, C35 aufweist, wobei jeder Hauptkondensator C29, C35 zur Verminderung des Einschaltstromes des Hochspannungsnetzteils 1 mit einem elektrischen Widerstand R2, R3 in Serie geschaltet ist, der über einen parallel geschalteten Transistor T5, T40 kurzschließbar ist, wobei die Steuereinheit 3 dazu eingerichtet ist, nach Ablauf einer vorgebbaren Einschwingzeitdauer diese seriellen Widerstände R2, und R3 mittels den parallel geschalteten Transistoren T5, T40 kurzzuschließen.

Die Erfindung betrifft ebenso ein in den Figuren nicht dargestelltes Beleuchtungssystem, umfassend ein erfindungsgemäßes Hochspannungsnetzteil 1 und eine durch das Hochspannungsnetzteil 1 versorgte Leuchteinheit.

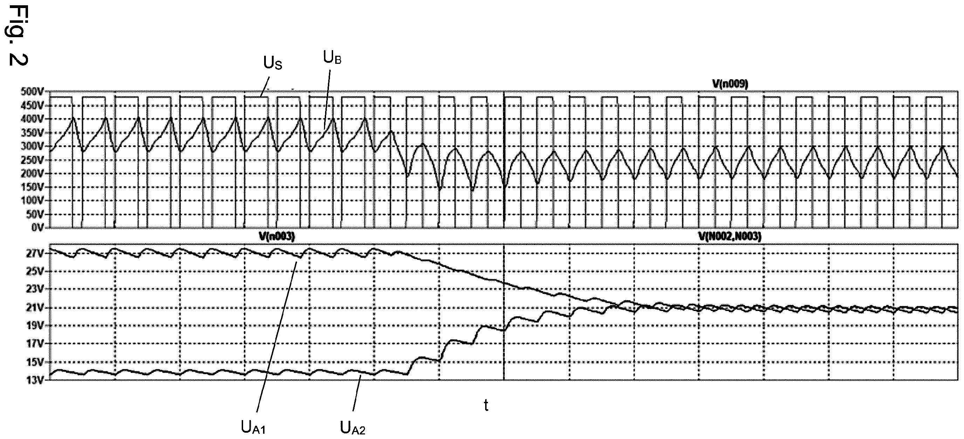

Figur 2 zeigt beispielhafte Spannungsverläufe an dem Hochspannungsnetzteil 1 gemäß Fig. 1. Darin ist in der oberhalb dargestellten Grafik entsprechend dem rechteckförmigen Verlauf die Spannung Us dargestellt, die mittels den Transistoren T1 bis T4 auf die Leistungstransformatorprimärspule T2-1 geschaltet wird. In dem vorliegenden Beispiel ist die Zeitdauer der Einschaltung des Transistorenpaares T1 und T2 länger als die Zeitdauer der Einschaltung des Transistorenpaares T3 und T4. Bei Einschaltung des Transistorenpaares T1 und T2 wird die Spannung am Punkt Us unter Vernachlässigung der Spannungsverluste der Transistoren auf das Spannungsniveau des Spannungseingangs U_{E} gezogen. Nach sperren des Transistorenpaares T1 und T2 und Einschalten des Transistorenpaares T3 und T4 wird der Punkt Us gegen Masse geschaltet, wodurch der rechteckförmige Verlauf der dargestellten Spannung Us (in Bezug auf Masse) zustande kommt. Die Brückenspannung U_{B} schwankt entsprechend dem Stromfluss in der Brücke im wesentlichen rechteckförmig, wobei das Ausmaß der Schwankung von der Dimensionierung der Brückenkondensatoren sowie der Leistungsaufnahme der Verbraucher abhängt. In dem ersten zeitlichen Drittel dieser Grafik ist erkennbar, dass die Zeitdauer, in der die Rechteckspannung im Zustand "high" ist, deutlich länger ist, als die Zeitdauer, in der diese Spannung den Wert "low", vorliegend Null, annimmt. Das bedeutet, dass die Transistorenpaare T1 und T2 bzw. T3 und T4 mit unterschiedliche Zeitdauer eingeschaltet sind, nämlich, dass vorliegend das Paar T1 und T2 länger durchgeschaltet ist als das Paar bestehend aus den Transistoren T3 und T4.

Dies hat zur Folge, dass die Ausgangsspannungen U_{A1} und U_{A2} unterschiedliche Werte annehmen. In Figur 2 ist zudem der Übergang hin zu einem symmetrischen Betrieb der Brückenzweige dargestellt. Darin ist die Zeitdauer, mit der beide Transistorenpaare im Durchlassbetrieb sind, gleich. Folglich sind die Rechteckpulse des Spannungsverlaufs Us symmetrisch und die Brückenspannung U_{B} nimmt im zeitlichen Mittel den Wert Us/2 an. Weiters gleichen sich die Ausgangsspannungen U_{A1} und U_{A2} an. Diese Spannungen können daher gezielt durch Veränderung der zeitlichen Dauer der jeweiligen Takthälften, bestimmt durch die Aktivierung des jeweiligen Transistorenpaares, bestimmt werden, wobei die Erfindung die Bestimmung der Zeitdauern wiederum auf elegante Weise durch Verwendung eines Steuerungstransformators möglich macht, der durch die bereits erwähnte Steuereinheit 3 manipuliert werden kann.

Die Steuereinheit 3 kann beispielsweise als Mikrokontroller ausgebildet sein, der Transistoren T7 und T6 steuert, mittels denen die entsprechende dritte bzw. vierte Steuertransformatorsekundärspule TR1-4 und TR1-5 kurzgeschlossen werden kann, wodurch in bereits erwähnter Weise eine Wechsel der Bestromung des Transistorenpaare von T1 und T2 hin zu T3 und T4 oder umgekehrt eingeleitet wird, wodurch eine Stromumkehr in der Leistungstransformatorprimärspule TR2-1 bewirkt wird.

In Anbetracht dieser Lehre ist der Fachmann in der Lage, ohne erfinderisches Zutun zu anderen, nicht gezeigten Ausführungsformen der Erfindung zu gelangen. Die Erfindung ist daher nicht auf die gezeigte Ausführungsform beschränkt, sondern durch den gesamten Schutzumfang der Ansprüche definiert. Auch können einzelne Aspekte der Erfindung bzw. der Ausführungsform aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

## Patentansprüche

1. Hochspannungsnetzteil (1) zur Wandlung einer Eingangsspannung von über 300 V Gleichspannung hin zu zumindest zwei Ausgangspannungen zwischen 2V und 100V, wobei das Hochspannungsnetzteil (1) zur Wandlung der Spannung
- einen Gegentaktwandler (2) aufweist, der mit
• einem Spannungseingang (U_{E}) zur Aufnahme der Eingangsspannung und
• zwei Spannungsausgängen zur Ausgabe von zwei Ausgangsspannungen (U_{A1}, U_{A2}) verbunden ist,
wobei der Gegentaktwandler (2) Brückenzweige aufweist und dazu ausgebildet ist, mit einer Schwingungsfrequenz zwischen 100 kHz und 1 MHz zu schwingen, wobei der Gegentaktwandler (2) zur Leistungsübertragung von dem Spannungseingang (U_{E}) hin zu den Spannungsausgängen (U_{A1}, U_{A2})
• einen Leistungstransformator mit einer mit dem Spannungseingang (U_{E}) verbundenen
∘ Leistungsprimärspule (TR2-1) und
∘ einer mit den Spannungsausgängen (U_{A1}, U_{A2}) verbundenen Leistungssekundärspule (TR2-2) aufweist, die mit der Leistungsprimärspule (TR2-1) magnetisch gekoppelt ist,
wobei die Spannungsausgänge (U_{A1}, U_{A2}) je nach Schaltphase des Gegentaktwandlers (2) wechselweise über die Leistungssekundärspule (TR2-2) bestromt und jeweils zumindest mittels eines Hilfskondensators (C4, C37) gestützt werden,
**dadurch gekennzeichnet, dass** der Gegentaktwandler (2) weiters
• einen Steuertransformator (TR1) aufweist, der zumindest einen Teil der Spannung an der Leistungsprimärspule (TR2-1) über einen elektrischen Widerstand (R1) mittels einer Steuertransformatorprimärspule TR1-1 abgreift, und zumindest drei mit der Steuertransformatorprimärspule magnetisch gekoppelte Steuertransformatorsekundärspulen (TR1-2 bis TR1-5) aufweist, wobei eine erste (TR1-2) und eine zweite (TR1-3) der zumindest drei Steuertransformatorsekundärspulen (TR1-2 bis TR1-5) dergestalt mit primärseitigen Schaltelementen (T2, T4) des Gegentaktwandlers (2) verschaltet sind, dass in Abhängigkeit von dem Erreichen einer Sättigung der Steuertransformatorprimärspule (TR1-1) die Schwingfrequenz eines frei selbstschwingenden Grundzustandes des Gegentaktwandlers (2) festgelegt ist, indem jedenfalls ein Sättigen der Steuertransformatorprimärspule (TR1-1) durch daraus resultierende Spannungssenkung an der ersten und zweiten Steuertransformatorsekundärspule (TR1-2, TR1-3) zu einem Wechsel des Vorzeichens der Bestromung der Leistungstransformatorprimärspule (TR2-1) führt, wobei das Hochspannungsnetzteil (1) weiters
- eine Steuereinheit (3) aufweist, wobei die Steuereinheit (3) mit der Sekundärseite des Gegentaktwandlers (2) zur elektrischen Versorgung der Steuereinheit (3) verbunden ist, wobei die Steuereinheit (3) ferner mit zumindest einer dritten Steuertransformatorsekundärwicklung (TR1-4, TR1-5) des Steuerungstransformators zur Manipulation der Spannung an derselben, nämlich zur zeitlich vorgebbaren Senkung der Spannung der zumindest dritten Steuertransformatorsekundärwicklung (TR1-4, TR1-5), insbesondere zum Kurzschließen derselben, verbunden ist,
wobei der Gegentaktwandler (2) dergestalt ausgelegt ist, dass durch diese Manipulation gleichermaßen die Spannung an der ersten und zweiten Steuertransformatorsekundärwicklung (TR1-2, TR1-3) aufgrund der magnetischen Kopplung der Steuertransformatorwicklungen (TR1-1 bis TR1-5) reduziert, insbesondere kurzgeschlossen, wird, und damit bereits vor Erreichen einer sich im frei schwingenden Grundzustand einstellenden Sättigung der Steuertransformatorprimärwicklung (TR1-1) ein Umschwingvorgang eingeleitet und somit die Arbeitsfrequenz des Gegentaktwandlers (2) über seine Grundschwingungsfrequenz hinaus erhöht wird, wobei die Steuereinheit (3) dazu eingerichtet ist, das Verhältnis der Einschaltzeitdauern der Brückenzweige des Gegentaktwandlers (2) abweichend von 50% vorzugeben und so auch das Verhältnis der Ausgangsspannungen zu verändern, in Abhängigkeit von einer vorgebbaren Gewichtung.

2. Hochspannungsnetzteil (1) nach Anspruch 1, wobei das Hochspannungsnetzteil (1) dazu eingerichtet ist, die Arbeitsfrequenz bis zumindest einem Faktor 2, vorzugsweise Faktor 3 über die Grundfrequenz hinaus zu erhöhen.

3. Hochspannungsnetzteil (1) nach Anspruch 1 oder 2, wobei der Steuertransformator eine vierte Steuertransformatorsekundärspule (TR1-5) aufweist, wobei die Steuereinheit (3) sowohl mit der dritten als auch mit der vierten Steuertransformatorsekundärspule (TR1-4, TR1-5) verbunden ist, wobei die dritte und die vierte Steuertransformatorsekundärspule (TR1-4, TR1-5) für komplementäre Schaltperioden des Gegentaktwandlers vorgesehen sind, und die Steuereinheit (3) dazu eingerichtet ist, die Spannung an beiden Steuertransformatorsekundärspulen (TR1-4, TR1-5) im jeweiligen Takt nacheinander und unabhängig voneinander zu manipulieren, insbesondere zu Senken und besonders bevorzugt kurzzuschließen.

4. Hochspannungsnetzteil (1) nach einem der vorhergehenden Ansprüche, wobei die Steuereinheit (3) dazu eingerichtet ist, die Spannung oder die Lastströme an beiden Spannungsausgängen (U_{A1}, U_{A2}) zu messen und das Verhältnis der Einschaltzeitdauern der Brückenzweige des Gegentaktwandlers (2) unter Berücksichtigung der vorgegebenen Gewichtung sowie der aktuell gemessenen Gewichtung zu manipulieren und eine etwaige Abweichung von der vorgegebenen Gewichtung zu reduzieren.

5. Hochspannungsnetzteil (1) nach einem der vorhergehenden Ansprüche, wobei der Steuertransformator (TR1) ein Niederspannungstransformator ist.

6. Hochspannungsnetzteil (1) nach Anspruch 5, wobei die Arbeitsspannung des Niederspannungstransformators zwischen 1 und 15V liegt.

7. Hochspannungsnetzteil (1) nach einem der vorhergehenden Ansprüche, wobei der Gegentaktwandler (2) an seiner Primärseite zwei Brückenzweige zur Teilung der Eingangsspannung aufweist, wobei jeder Brückenzweig je zwei in Serie geschaltete Schaltelemente (T1, T2, T3, T4) aufweist, nämlich je einen Hochspannungstransistor (T1, T3) und einen Niederspannungstransistor (T2, T4), wobei die erste und zweite Steuertransformatorsekundärspulen (TR1-2, TR1-3) jeweils dergestalt verschaltet sind, dass ein Lastwechsel zwischen den Brückenzweigen durch ein Abschalten des jeweils in Betrieb befindlichen Niederspannungstransistors (T2, T4) eingeleitet wird, wodurch die Spannungsdifferenz am Steuereingang des seriell geschalteten Hochspannungstransistors (T1, T3) sinkt und dieser ebenso abschaltet, wobei aufgrund der Induktivität des Leistungstransfomators eine Spannungsumkehr an der Steuertransformatorprimärwicklung (TR1-1) stattfindet, die auf die Steuertransformatorsekundärwicklungen (TR1-2, TR1-3) übertragen wird und ein Durchschalten der vor dem Lastwechsel nicht in Betrieb befindlichen Transistoren (T3 und T4 oder T1 und T2) bewirkt und damit den Lastwechsel zwischen den Brückenzweigen vollzieht.

8. Hochspannungsnetzteil (1) nach einem der vorhergehenden Ansprüche, wobei die zwei Spannungsausgänge (U_{A1}, U_{A2}) jeweils durch einen Hauptkondensator (C29, C35) gestützt sind, der eine größere Kapazität als der jeweilige Hilfskondensator (C4, C37) aufweist, wobei jeder Hauptkondensator (C4, C37) zur Verminderung des Einschaltstromes des Hochspannungsnetzteils (1) mit einem elektrischen Widerstand (R2, R3) in Serie geschaltet ist, der über einen parallel geschalteten Transistor (T5, T40) kurzschließbar ist, wobei die Steuereinheit (3) dazu eingerichtet ist, nach Ablauf einer vorgebbaren Einschwingzeitdauer diese seriellen Widerstände (R2 und R3) mittels den parallel geschalteten Transistoren (T5, T40) kurzzuschließen.

9. Beleuchtungssystem, umfassend ein Hochspannungsnetzteil (1) nach einem der vorhergehenden Ansprüche und eine durch das Hochspannungsnetzteil (1) versorgte Leuchteinheit.

10. Beleuchtungssystem nach Anspruch 9, wobei die Leuchteinheit zumindest zwei Lichtquellen aufweist, wobei eine Lichtquelle mit dem ersten Spannungsausgang (U_{A1}) und eine weitere Lichtquelle mit dem zweiten Spannungsausgang (U_{A2}) verbunden ist

11. Beleuchtungseinheit nach Anspruch 10, wobei die zumindest zwei Lichtquellen dazu eingerichtet sind, in Abhängigkeit von der die Lichtquellen versorgenden Spannung den abgestrahlten Lichtstrom und/ oder die Lichtfarbe zu variieren.

## Claims

1. High-voltage power supply (1) for converting an input voltage of more than 300 V DC to at least two output voltages between 2 V and 100 V, the high-voltage power supply (1) comprising for converting the voltage
- a push-pull converter (2), which is connected to a
- a voltage input (UE) for receiving the input voltage and
- two voltage outputs for the output of two output voltages (UA1, UA2),
the push-pull converter (2) having bridge branches and being adapted to oscillate at an oscillation frequency between 100 kHz and 1 MHz, wherein for power transfer from the voltage input (UE) to the voltage outputs (UA1, UA2) the push-pull converter (2) comprises
- a power transformer with
- a power primary coil (TR2-1) connected to the voltage input (UE) and
- a power secondary coil (TR2-2) connected to the voltage outputs (UA1, UA2) and magnetically coupled to the power primary coil (TR2-1),
the voltage outputs (UA1, UA2) being alternately energized via the power secondary coil (TR2-2) depending on the switching phase of the push-pull converter (2) and being supported in each case at least by means of an auxiliary capacitor (C4, C37), **characterized in that** the push-pull converter (2) further comprises
- a control transformer (TR1) which taps off at least part of the voltage at the power primary coil (TR2-1) via an electrical resistor (R1) by means of a control transformer primary coil TR1-1 and has at least three control transformer secondary coils (TR1-2 to TR1-5) magnetically coupled to the control transformer primary coil, a first (TR1-2) and a second (TR1-3) of the at least three control transformer secondary coils (TR1-2 to TR1-5) being connected to primary-side switching elements (T2, T4) of the push-pull converter (2) in such a way that the oscillation frequency of a freely self-oscillating basic state of the push-pull converter (2) is fixed as a function of the control transformer primary coil (TR1-1) reaching saturation, **in that**, in any case, saturation of the control transformer primary coil (TR1-1) leads to a change in the sign of the energization of the power transformer primary coil (TR2-1) as a result of a resulting voltage reduction at the first and second control transformer secondary coils (TR1-2, TR1-3), wherein the high-voltage power supply unit (1) further comprises
- a control unit (3), wherein the control unit (3) is connected to the secondary side of the push-pull converter (2) for the electrical supply of the control unit (3), wherein the control unit (3) is further connected to at least one third control transformer secondary winding (TR1-4, TR1-5) of the control transformer for manipulating the voltage at the same, namely for lowering the voltage of the at least third control transformer secondary winding (TR1-4, TR1-5), in particular for short-circuiting the same, in a manner which can be predetermined in terms of time, with the push-pull converter (2) being designed in such a way that, as a result of this manipulation, the voltage at the first and second control transformer secondary winding (TR1-2, TR1-3) is reduced, in particular short-circuited, as a result of the magnetic coupling of the control transformer windings (TR1-1 to TR1-5), and thus a changeover process is initiated even before the control transformer primary winding (TR1-1) reaches saturation, which occurs in the freely oscillating fundamental state, and thus the operating frequency of the push-pull converter (2) is increased above its fundamental frequency, wherein the control unit (3) is set up to preset the ratio of the on-time durations of the bridge branches of the push-pull converter (2) deviating from 50% and thus also to change the ratio of the output voltages, depending on a presettable weighting.

2. High-voltage power supply (1) according to claim 1, wherein the high-voltage power supply (1) is set up to increase the operating frequency by at least a factor of 2, preferably a factor of 3, above the fundamental frequency.

3. High voltage power supply (1) according to claim 1 or 2, wherein the control transformer comprises a fourth control transformer secondary coil (TR1-5), wherein the control unit (3) is connected to both the third and the fourth control transformer secondary coil (TR1-4, TR1-5), wherein the third and the fourth control transformer secondary coil (TR1-4, TR1-5) are provided for complementary switching periods of the push-pull converter, and the control unit (3) is set up to manipulate the voltage at both control transformer secondary coils (TR1-4, TR1-5) successively and independently of one another in the respective clock cycle, in particular to lower and, particularly preferably, to short-circuit them.

4. High-voltage power supply (1) according to one of the preceding claims, wherein the control unit (3) is set up to measure the voltage or the load currents at both voltage outputs (UA1, UA2) and to manipulate the ratio of the on-time durations of the bridge branches of the push-pull converter (2), taking into account the predetermined weighting as well as the currently measured weighting, and to reduce any deviation from the predetermined weighting.

5. High-voltage power supply (1) according to any of the preceding claims, wherein the control transformer (TRI) is a low-voltage transformer.

6. High voltage power supply (1) according to claim 5, wherein the working voltage of the low voltage transformer is between 1 and 15V.

7. High-voltage power supply (1) according to one of the preceding claims, wherein the push-pull converter (2) has two bridge branches on its primary side for dividing the input voltage, each bridge branch having two series-connected switching elements (T1, T2, T3, T4), namely one high-voltage transistor (T1, T3) and a low-voltage transistor (T2, T4), the first and second control transformer secondary coils (TR1-2, TR1-3) each being connected in such a way that a load change between the bridge branches is initiated by switching off the respective operating low-voltage transistor (T2, T4) which is in operation in each case, as a result of which the voltage difference at the control input of the series-connected high-voltage transistor (T1, T3) decreases and the latter likewise switches off, with a voltage reversal taking place at the control transformer primary winding (TR1-1) on account of the inductance of the power transformer, which is transferred to the control transformer secondary windings (TR1-2, TR1-3) and causes switching through of the transistors (T3 and T4 or T1 and T2) which are not in operation before the load change, thus completing the load change between the bridge branches.

8. High voltage power supply (1) according to any one of the preceding claims, wherein the two voltage outputs (UA1, UA2) are each supported by a main capacitor (C29, C35) having a larger capacitance than the respective auxiliary capacitor (C4, C37), wherein each main capacitor (C4, C37) being connected in series with an electrical resistor (R2, R3) which can be short-circuited via a transistor (TS, T40) connected in parallel in order to reduce the inrush current of the high-voltage power supply unit (1), the control unit (3) being set up to short-circuit these series resistors (R2 and R3) by means of the transistors (TS, T40) connected in parallel after a prescribable transient period has elapsed.

9. Lighting system, comprising a high-voltage power supply (1) according to one of the preceding claims and a lighting unit supplied by the high-voltage power supply (1).

10. Lighting system according to claim 9, wherein the lighting unit comprises at least two light sources, one light source being connected to the first voltage output (UA1) and another light source being connected to the second voltage output (UA2)

11. Lighting unit according to claim 10, wherein the at least two light sources are arranged to vary the emitted luminous flux and/or the light color depending on the voltage supplying the light sources.

## Revendications

1. Alimentation haute tension (1) pour convertir une tension d'entrée de plus de 300 V DC en au moins deux tensions de sortie entre 2 V et 100 V, dans laquelle l'alimentation haute tension (1) comprend pour convertir la tension
- a un convertisseur push-pull (2) qui a
- une entrée de tension (UE) pour recevoir la tension d'entrée et
- deux sorties tension pour délivrer deux tensions de sortie (UA1, UA2) connecté,
le convertisseur push-pull (2) ayant des branches de pont et étant adapté pour osciller à une fréquence d'oscillation entre 100 kHz et 1 MHz, dans lequel pour le transfert de puissance de l'entrée de tension (UE) aux sorties de tension (UA1, UA2) le convertisseur push-pull (2) comprend
- un transformateur de puissance avec une bobine primaire de puissance (TR) connectée à l'entrée de tension (UE), et
- une bobine primaire de puissance (TR2-1) connectée à l'entrée de tension (UE) et
- une bobine secondaire de puissance (TR2-2) connectée aux sorties de tension (UA1, UA2) et couplée magnétiquement à la bobine primaire de puissance (TR2-1),
les sorties de tension (UA1, UA2) sont alimentées alternativement en courant par l'intermédiaire de la bobine secondaire de puissance (TR2-2) en fonction de la phase de commutation du convertisseur push-pull (2) et sont assistées à chaque fois au moins par un condensateur auxiliaire (C4, C37), **caractérisé en ce que** le convertisseur push-pull (2) présente en outre
- a un transformateur de commande (TR1) qui prélève au moins une partie de la tension au niveau de la bobine primaire de puissance (TR2-1) via une résistance électrique (R1) au moyen d'une bobine primaire de transformateur de commande TR1-1 et a au moins trois bobines secondaires de transformateur de commande (TR1-2 à TR1-5) couplées magnétiquement à la bobine primaire du transformateur de commande, une première (TR1-2) et une seconde (TR1-3) des au moins trois bobines secondaires de transformateur de commande (TR1-2 à TR1-5) étant connectées à des éléments de commutation du côté primaire (T2, T4) du convertisseur push-pull (2) de telle sorte que la fréquence d'oscillation d'un état de base librement auto-oscillant du convertisseur push-pull (2) est fixée en fonction de l'atteinte de la saturation de la bobine primaire du transformateur de commande (TR1-1), **en ce que**, dans tous les cas, la saturation de la bobine primaire du transformateur de commande (TR1-1) conduit à un changement du signe du courant circulant à travers la bobine primaire du transformateur de puissance (TR2-1) en raison de la réduction de tension aux première et deuxième bobines secondaires du transformateur de commande (TR1-2, TR1-3) qui en résulte,
l'unité d'alimentation électrique haute tension (1) comprenant en outre
- une unité de commande (3), dans laquelle l'unité de commande (3) est connectée au côté secondaire du convertisseur push-pull (2) pour l'alimentation électrique de l'unité de commande (3), dans laquelle l'unité de commande (3) est en outre connectée à au moins un troisième enroulement secondaire de transformateur de commande (TR1-4, TR1-5) du transformateur de commande pour manipuler la tension sur celui-ci, c'est-à-dire pour abaisser la tension du au moins troisième enroulement secondaire de transformateur de commande (TR1-4, TR1-5), en particulier pour le court-circuiter, d'une manière qui peut être prédéterminée dans le temps, le convertisseur push-pull (2) étant conçu de telle sorte que, à la suite de cette manipulation, la tension au niveau des premier et deuxième enroulements secondaires de transformateur de commande (TR1-2, TR1-3) est réduite, en particulier court-circuitée, par le couplage magnétique des enroulements du transformateur de commande (TR1-1 à TR1-5), et ainsi un processus de commutation est initié avant même qu'une saturation de l'enroulement primaire du transformateur de commande (TR1-1), qui se produit dans l'état de base oscillant librement, soit atteinte, et ainsi la fréquence de fonctionnement du convertisseur push-pull (2) est augmentée au-delà de sa fréquence d'oscillation de base, dans lequel l'unité de commande (3) est configurée pour prérégler le rapport des durées d'enclenchement des branches du pont du convertisseur push-pull (2) s'écartant de 50 % et pour modifier ainsi également le rapport des tensions de sortie, en fonction d'une pondération préréglable.

2. Alimentation haute tension (1) selon la revendication 1, dans laquelle l'unité d'alimentation haute tension (1) est configurée pour augmenter la fréquence de fonctionnement d'au moins un facteur 2, de préférence un facteur 3, au-dessus de la fréquence fondamentale.

3. Alimentation haute tension (1) selon la revendication 1 ou 2, dans laquelle le transformateur de commande comprend une quatrième bobine secondaire de transformateur de commande (TR1-5), dans laquelle l'unité de commande (3) est connectée à la fois à la troisième et à la quatrième bobine secondaire de transformateur de commande (TR1-4, TR1-5), dans laquelle la troisième et la quatrième bobine secondaire de transformateur de commande (TR1-4, TR1-5) sont prévus pour des périodes de commutation complémentaires du convertisseur push-pull, et l'unité de commande (3) est configurée pour manipuler la tension sur les deux bobines secondaires du transformateur de commande (TR1-4, TR1-5) successivement et indépendamment l'une de l'autre dans le cycle d'horloge respectif, en particulier pour les abaisser et, particulièrement préférablement, les court-circuiter.

4. Alimentation haute tension (1) selon l'une des revendications précédentes, dans laquelle l'unité de commande (3) est conçue pour mesurer la tension ou les courants de charge aux deux sorties de tension (UA1, UA2) et pour manipuler le rapport des durées d'enclenchement des branches du pont du convertisseur push-pull (2) en tenant compte de la pondération prédéterminée ainsi que de la pondération actuellement mesurée et pour réduire tout écart par rapport à la pondération prédéterminée.

5. Alimentation haute tension (1) selon l'une quelconque des revendications précédentes, dans laquelle le transformateur de commande (TRI) est un transformateur basse tension.

6. Alimentation haute tension (1) selon la revendication 5, dans laquelle la tension de fonctionnement du transformateur basse tension est comprise entre 1 et 15V.

7. Alimentation haute tension (1) selon l'une des revendications précédentes, dans laquelle le convertisseur push-pull (2) présente sur son côté primaire deux branches de pont pour diviser la tension d'entrée, chaque branche de pont présentant à chaque fois deux éléments de commutation (T1, T2, T3, T4) montés en série, à savoir à chaque fois un transistor haute tension (T1, T3) et un transistor basse tension (T2, T4), dans lequel les première et deuxième bobines secondaires (TR1-2, TR1-3) du transformateur de commande sont chacune connectées de telle manière qu'un changement de charge entre les branches du pont est initié par la mise hors tension du transistor basse tension de fonctionnement respectif (T2, T3, T4), T4), qui est en service dans chaque cas, ce qui fait que la différence de tension à l'entrée de commande du transistor haute tension monté en série (T1, T3) diminue et que ce dernier s'arrête également, une inversion de tension se produisant sur l'enroulement primaire du transformateur de commande (TR1-1) en raison de l'inductance du transformateur de puissance, qui est transféré aux enroulements secondaires du transformateur de commande (TR1-2, TR1-3) et provoque une commutation des transistors (T3 et T4 ou T1 et T2) qui ne sont pas en fonctionnement avant le changement de charge, et réalise ainsi le changement de charge entre les branches du pont.

8. Alimentation haute tension (1) selon l'une quelconque des revendications précédentes, dans laquelle les deux sorties de tension (UA1, UA2) sont chacune supportées par un condensateur principal (C29, C35) ayant une plus grande capacité que le condensateur auxiliaire respectif (C4, C37), dans laquelle chaque condensateur principal (C4, C37) étant monté en série avec une résistance électrique (R2, R3), qui peut être court-circuitée par l'intermédiaire d'un transistor (TS, T40) monté en parallèle, afin de réduire le courant d'appel du bloc d'alimentation haute tension (1), l'unité de commande (3) étant configurée pour court-circuiter ces résistances en série (R2 et R3) au moyen des transistors (TS, T40) montés en parallèle après l'écoulement d'une période transitoire pouvant être prescrite.

9. Système d'éclairage comprenant une unité d'alimentation haute tension (1) selon l'une des revendications précédentes et une unité d'éclairage alimentée par l'unité d'alimentation haute tension (1).

10. Système d'éclairage selon la revendication 9, dans lequel l'unité d'éclairage comprend au moins deux sources de lumière, une source de lumière étant connectée à la première sortie de tension (UA1) et une autre source de lumière étant connectée à la deuxième sortie de tension (UA2).

11. Unité d'éclairage selon la revendication 10, dans laquelle les au moins deux sources lumineuses sont agencées pour faire varier le flux lumineux émis et/ou la couleur de la lumière en fonction de la tension alimentant les sources lumineuses.
